# EUROPEAN PATENT APPLICATION

(11) **EP 2 830 170 A1**
(43) Date of publication of application: **28.01.2015**
(21) Application number: 13177612.2
(22) Date of filing: 23.07.2013
(51) Int. Cl.: H02B 1/01

(54) **A mounting bracket for a cabinet of an electrical switchboard**

(71) Applicant: ABB S.p.A., 20124 Milano (IT)
(72) Inventor: Frattaruolo, Massimo, 20837 Veduggio con Colzano (MB) (IT); Proserpio, Simone Angelo, 22039 Valbrona (CO) (IT)
(74) Representative: De Santis, Giovanni

(57) **Abstract**

A mounting bracket (1) adapted to be operatively connected to the frame (100) of a switchboard cabinet (300), the frame comprising at least one frame member (101) having a first wall (102) comprising a plurality of first holes (110, 111), and a second wall (103) comprising a plurality of second holes (112, 113) and arranged transversal to the first wall.

The mounting bracket comprises:
- a flat surface (30) adapted to abut against the first wall;
- at least one element (10, 11) protruding transversally with respect to the flat surface and adapted to be inserted into a corresponding one of the first holes, by abutting the flat surface against the first wall;
- elastic means (20) adapted to interact with and be elastically repulsed by the second wall during the insertion of the at least one element into the corresponding first hole, and to elastically return and engage with corresponding one or more of the second holes when the flat surface abuts against the first wall.

## Description

The present invention relates to a mounting bracket adapted to be operatively connected to the frame of a cabinet for an electrical switchboard.

As known, a switchboard, such as a distribution or automation switchboard, comprises a cabinet having a frame which defines an internal space for housing one or more electric or electronic elements and/or components of the switchboard. For example, the frame of a low voltage distribution switchboard houses switching devices, e.g. circuit breakers, bus bars, control buttons, cable conduits, supporting guides, et cetera.

Generally, the frame has a substantially parallelepiped structure which is defined by frame members which are arranged substantially horizontally, commonly known as cross-members or rails, and by frame members which are arranged vertically and are commonly known as uprights. The structure of the frame so realized constitutes a structural skeleton to which various components and/or accessories are operatively connected.

For example, a kit is used for mounting one or more electrical devices, such as switching devices, internally to the frame; the kit comprises a plate for supporting the electrical devices, and mounting brackets for operatively connecting the supporting plate to the frame.

According to a first know solution, a first mounting bracket transversally connects a first upright of the frame to a vertical structural element associated to frame, such as a second upright or a first vertical panel mounted between the first and second uprights.

A second mounting bracket transversally connects a third upright of the frame to a vertical structural element associated to the frame, such as a fourth upright or a second vertical panel mounted between the third and fourth uprights.

The mounting plate is installed between and connected to the first and second mounting brackets. The first and second mounting brackets are fixed to the corresponding uprights or other vertical structural elements associated to the frame by means of several fixing screws. The brackets have to be kept by the operator in the correct position onto the corresponding uprights or other vertical structural elements during the fixing operation.

Hence, the disclosed first known solution is expensive, complex, and implies a waste of time to be executed.

According to a known second solution, the bracket, instead of requiring a fixing operation, comprise elastic means for its connection to a corresponding upright of the frame. First, the elastic means are inserted into corresponding holes of the upright; this preliminary operation does not provide an action of the elastic means for connecting the bracket to the upright. This action is achieved only by subsequently rotating the bracket for engaging its elastic means with the internal surface of the upright.

This connection operation is complex, requiring both a linear inserting movement and a subsequent rotational movement of the bracket; furthermore, the elastic means are subjected to high mechanical stress and they can be damaged upon several connecting operations.

In light of above, at the current state of the art, although known solutions perform in a rather satisfying way, there is still reason and desire for further improvements.

Such desire is fulfilled by a mounting bracket adapted to be operatively connected to the frame of a cabinet for an electrical switchboard. The frame comprises at least one frame member having at least a first wall which comprises a plurality of first holes and a second wall which comprises a plurality of second holes and which is arranged transversal with respect to the first wall. The mounting bracket comprises:
- a flat surface adapted to abut against the first wall;
- at least one element which protrudes transversally with respect to the flat surface and which is adapted to be inserted into a corresponding one of the first holes by abutting the flat surface against the first wall;
- elastic means adapted to interact with and be elastically repulsed by the second wall during the insertion of the at least one element into the corresponding first hole, and to elastically return and engage with corresponding one or more of the second holes when the flat surface abuts against the first wall and the at least one element is inserted into the corresponding first hole.

Another aspect of the present disclosure is to provide a cabinet as the cabinet defined in the annexed claims and disclosed in the following description.

Another aspect to the present disclosure is to provide an electrical switchboard comprising a cabinet as the cabinet defined in the annexed claims and disclosed in the following description.

Further characteristics and advantages will be more apparent from the description of an exemplary, but non-exclusive, embodiment of a mounting bracket, and related cabinet and switchboard, according to the present invention, illustrated only for non-limitative exemplary purposes in the accompanying drawings, wherein:
- figures 1 and 2 are two perspective views, from different angles, of a mounting bracket according to the present invention in phase of connection with a corresponding frame member;
- figures 3 and 4 are two perspective views, from different angles, of the mounting bracket and the corresponding frame member illustrated in figures 1 and 2, which are connected to the each other;
- figures 5 and 6 are two perspective views, from different angles, of elastic means of the mounting bracket illustrated in figures 1-4;
- figure 7 shows the elastic means illustrated in figures 5 and 6, in phase of assembly with a main body of the mounting bracket;
- figures 8 and 9 are a lateral view and an upper view, respectively, of the frame member and connected mounting bracket illustrated in figures 3-4;
- figure 10 is a detail of figure 9, wherein the elastic means of the bracket are make viewable to better illustrate their engagement with corresponding holes of the frame member;
- figure 11 illustrates a sliding element of a mounting bracket according to the present invention;
- figures 12 illustrates a switchboard cabinet without the front door and the lateral panels, so as to make viewable: the cabinet frame, four mounting brackets according to the present invention which are operatively connected to the cabinet frame, and a supporting plate connected to the four mounting brackets;
- figure 13 illustrates a detail of figure 12; and
- figure 14 illustrates the switchboard cabinet of figure 12 with the front door and the lateral panels.

It should be noted that in the detailed description that follows, identical or similar components, either from a structural and/or functional point of view, have the same numeral references, regardless of whether they are shown in different embodiments; it should also be noted that in order to clearly and concisely describe the present invention, the drawings may not necessarily be to scale and certain features of the disclosure may be shown in somewhat schematic form. Further, when the term "adapted" is used herein while referring to any component as a whole, or to any part of a component, or to a whole combinations of components, or even to any part of a combination of components, it has to be understood that it means and encompasses the structure, and/or configuration and/or shape and/or positioning of the related component or part thereof, or combinations of components or part thereof, such term refers to.

Further, the term "transversal" or "transversally" is used herein to describe the position of one or more first parts and/or components relative to other second parts and/or components, so as to encompass all the positions where such first parts and/or components are not parallel with respect to the other second parts and/or components; hence, the meaning of "transversal" or "transversally" is not in any way herein limited to the particular case where such first parts and/or components are perpendicular to the second parts and/or components.

With reference to the above cited figures, the present invention is related to a mounting bracket 1 (hereinafter indicated for sake of simplicity as "bracket 1") which is adapted to be operatively connected to the frame 100 of an electrical switchboard cabinet 300.

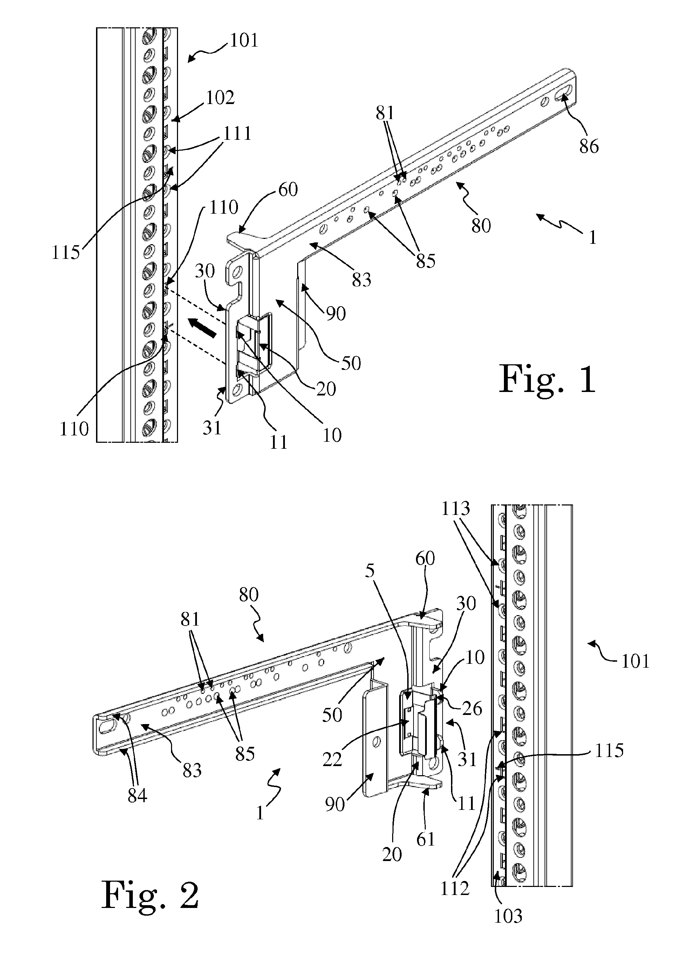

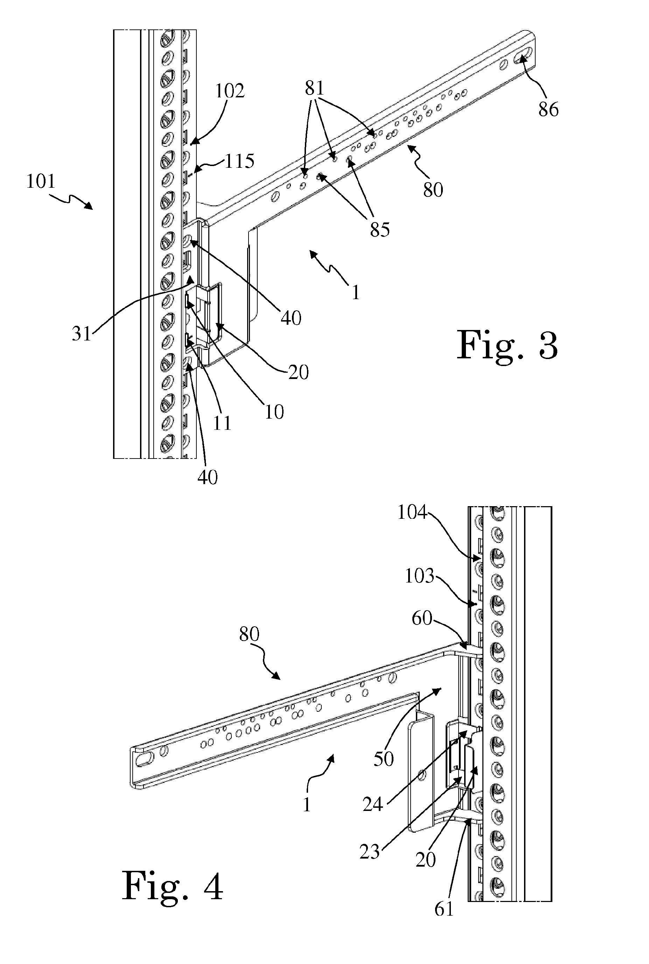

In particular, with reference to figures 1-4 and 8-10, the bracket 1 is adapted to be operatively connected to the frame 100 by coupling with a corresponding member 101 of the frame 100 (hereinafter indicated for sake of simplicity as "frame member 101").

The frame member 101 has at least a first wall 102 which comprises a plurality of first holes 110, 111, and a second wall 103 which comprises a plurality of second holes 112, 113 and which is arranged transversal with respect to the first wall 102.

According to the exemplary embodiment illustrated in figures 1-4 and 8-10, the first and second walls 102, 103 are preferably perpendicularly connected to each other. Furthermore, the frame member 101 illustrated for exemplary purpose in figures 1-4 and 8-10 has a row of first holes 110, 111 along its lengthwise extension, comprising rectangular first holes 110 alternated to circular first holes 111; in the same way, the second wall 103 has a row of second holes 112, 113 along its lengthwise extension, comprising rectangular second holes 112 alternated to circular second holes 113.

In order to operatively couple with the frame member 101, the bracket 1 comprises:
- a flat surface 30 adapted to abut against the first wall 102 of the frame member 101;
- at least one element 10, 11 which protrudes transversally with respect to the flat surface 30 and which is adapted to be inserted into a corresponding one of the first holes 110, 111, by abutting the flat surface 30 against the first wall 102; and
- elastic means 20 adapted to interact with and be elastically repulsed by the second wall 103 of the frame member 101 during the insertion of the at least one element 10, 11 into the corresponding first hole 110, 111, and to elastically return and engage with corresponding one or more of the second holes 112, 113 when the flat surface 30 abuts against the first wall

102 and the at least one element 10, 11 is inserted into the corresponding first hole 110, 111. In practice, the elastic repulsion caused by the second wall 103 corresponds to a deformation of the elastic means 20 from a rest position (i.e. the position of the elastic means 20 when the bracket 1 is disengaged from the frame member 101) to a first elastically deformed position. The subsequent engagement of the elastic means 20 with the corresponding one or more second holes 112, 113 causes the return thereof from the first elastically deformed position towards the rest position.

Advantageously, the bracket 1 so conceived can be connected to the frame member 101 with only a single mounting operation occurring along a linear direction which is defined by the insertion of the at least one element 10, 11 into the corresponding first hole 110 (as illustrated for example in figure 1, where such linear direction is depicted by an arrow).

Preferably, the elastic means 20 are adapted to exert a force F_{E} which is directed towards and acts on the second wall 103, after the engagement of the elastic means 102 with the corresponding one or more second holes 112, 113. In this way, the force F_{E} contributes to keep the bracket 1 stably and effectively coupled to the frame member 101.

For example, the elastic means 20 are adapted to engage with the corresponding one or more second holes 112, 113 so as to return from the first elastically deformed position to a second elastically deformed position which is between the first elastically deformed position and the rest position. In this way, the elastic means 20 continue to exert the force F_{E} on the second wall 103 for returning at the rest position on the second wall 103, while trying to return at the rest position.

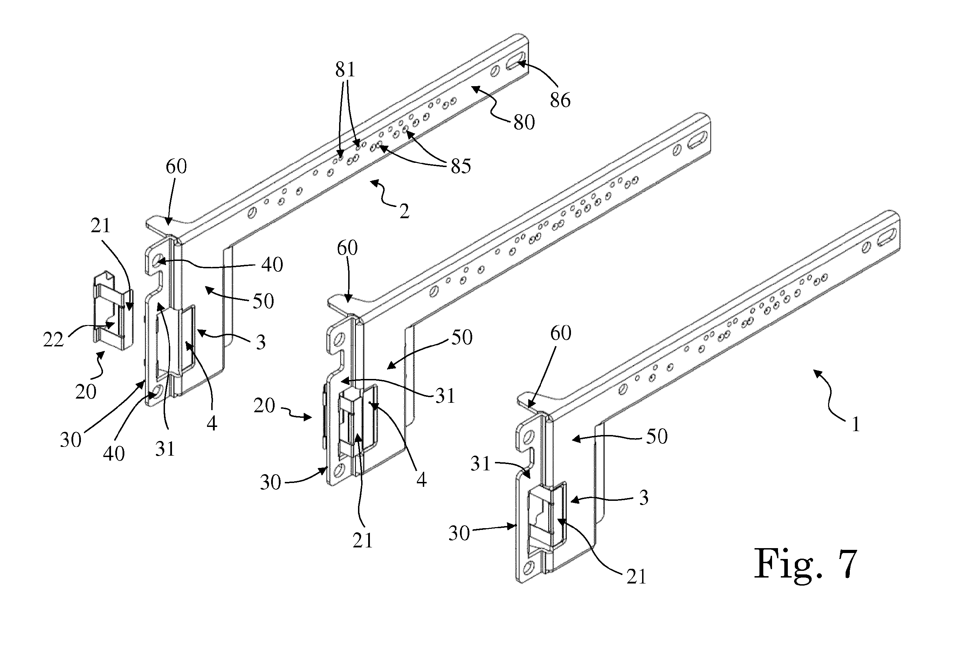

With particular reference to figure 7, the exemplary bracket 1 illustrated in figures 1-4 and 7-10 comprises a main body 2, for example made of galvanized steel, and its elastic means 20 comprise a spring 20, for example made of spring steel, which is associated to the main body 2. Preferably, the spring 20 is pre-assembled with the main body 2 during the manufacturing of the bracket 1, so as no further assembling operations are required by customers. For example, the spring 20 is operatively coupled to a corresponding seat 3 defined in the main body 2.

In the exemplary embodiment illustrated in figures 1-4 and 7-10, the main body 2 comprises a flat portion 31 which provides the flat surface 30 adapted to abut against the first wall 102 of the frame member 101.

A first tooth 10 and a second tooth 11 are connected to the flat portion 31 so as to protrude transversally with respect to the flat surface 30. The first and second teeth 10, 11 are adapted to be inserted in corresponding two rectangular first holes 110 of the first wall 102, when the flat surface 30 of the flat portion 31 abuts against the first wall 102.

Preferably, the bracket 1 comprises at least one fixing hole 40 defined on the flat surface 30; the exemplary bracket 1 illustrated in figures 1-4 and 7-10 comprises two fixing holes 40 which are defined through the flat portion 31, at and upper end and at a lower end of such portion 31. The two fixing holes 40 are adapted to be aligned to corresponding circular first holes 111, when the flat surface 30 abuts against the first wall 102.

Preferably, according to the exemplary embodiment illustrated in figures 1-4 and 8-10, the frame member 101 further comprises a third wall 104 which is transversally connected to the second wall 103; in particular, the illustrated first and third walls 102 and 104 are parallel to each other and transversally connected by the second wall 103.

Accordingly, the bracket 1 advantageously comprises one or more shaped portions 60, 61 which are adapted to abut against the third wall 104, when the flat surface 30 abuts against the first wall 102.

Preferably, the one or more shaped portions 60, 61 are further adapted to slide on the second wall 103 during the insertion of the at least one connecting element 10, 11 into the corresponding first hole 110. Further, the one or more shaped portions 60, 61 are adapted to remain in contact with the second wall 103 when the flat surface 30 abuts against the first wall 102 and the at least one element 10, 11 is inserted into the corresponding first holes 110.

In the exemplary embodiment illustrated in figures 1-4 and 7-10, the main body 2 of the bracket 1 comprises a further flat portion 50 which is connected and staggered with respect to the flat portion 31; a first shaped portion 60 and a second shaped portion 61 protrude transversally from opposed ends of the flat portion 50.

The first and second shaped portions 60, 61 are adapted to:
- slide on the second wall 103 of the frame member 101 during the insertion of the teeth 10, 11 into the corresponding first holes 110 of the first wall 102; and
- abut against the third wall 104 and contact the second the second wall 103, when the flat surface 30 of the portion 31 abuts against the first wall 102 and the teeth 10, 11 are inserted into the corresponding first holes 110.

The exemplary bracket 1 illustrated in figures 1-4 and 7-10 further comprises a tab 90 which is connected to the flat portion 50 and which is adapted to be operatively connected to a panel for the segregation of the cabinet 300.

According to the exemplary embodiment illustrated in figures 1-10, the spring 20 of the bracket 1 comprises a flat portion 21 which is arranged substantially parallel with respect to the flat surface 30 of the main body 2.

For example, the seat 3 for the spring 20 is defined in the flat portion 50 of the main body 2 and comprises a mounting surface 4 which is defined substantially parallel with respect to the flat surface 30. The flat portion 21 of the spring 20 is adapted to be mounted on the mounting surface 4.

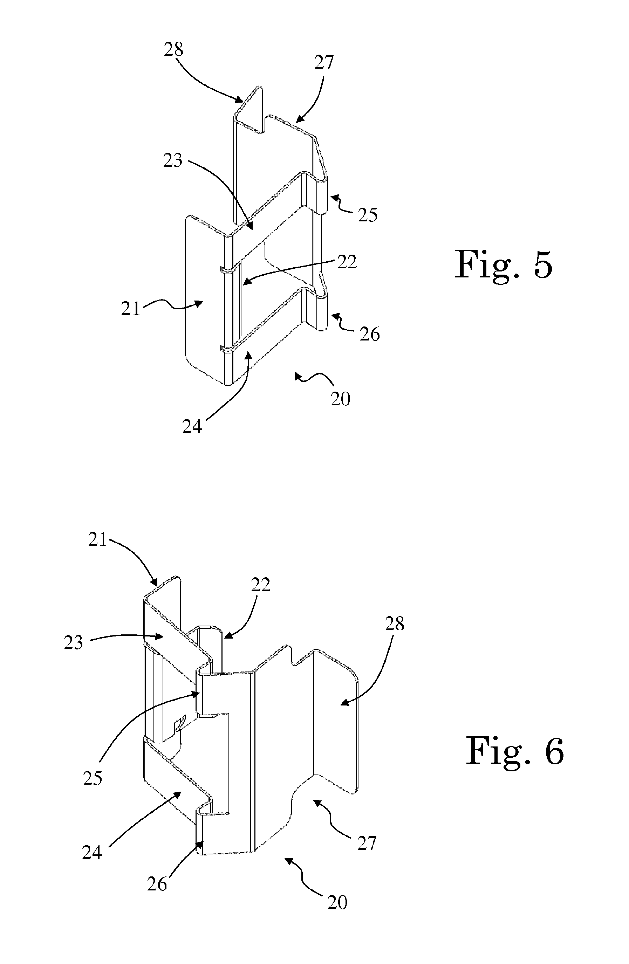

Furthermore, with reference to figure 6, the spring 20 can comprise a gripping portion 22 connected to the flat portion 21 and adapted to grip a corresponding portion 5 of the seat 3; such gripped portion 5 being opposed to the mounting surface 4 of the flat portion 21.

The spring 20 further comprises two protruding portions 23 and 24 which protrude transversally from the flat portion 21, so as to be arranged substantially transversally with respect to the flat surface 30.

The protruding portions 23 and 24 are adapted to operatively interact with and being repulsed by the second wall 103 of the frame member 101, during the insertion of the teeth 10, 11 into the corresponding first holes 110, and to elastically return and engage with corresponding rectangular second holes 112 of the second wall 103, when the flat surface 30 abuts against the first wall 102 and the teeth 10, 11 are inserted into the corresponding first holes 110.

In the exemplary embodiment illustrated in figures 5-6, the first protruding portion 23 and the second protruding portion 24 comprises a first folded tract 25 and a second folded tract 26, respectively, which are adapted to contact the second wall 102 during the insertion of the teeth 10, 11 into the corresponding first holes 110; such contact causing the elastic repulsion of the protruding portions 23, 24, from a rest position to a first elastically deformed position.

The folded tracts 25 and 26 are further adapted to insert into corresponding rectangular second holes 112, when the flat surface 30 abuts against the first wall 102 and the teeth 10, 11 are inserted into the corresponding first holes 110. This insertion causes the elastic return of the protruding portions 23, 24 from the first elastically deformed to a second elastically deformed position between the rest and first elastically deformed positions.

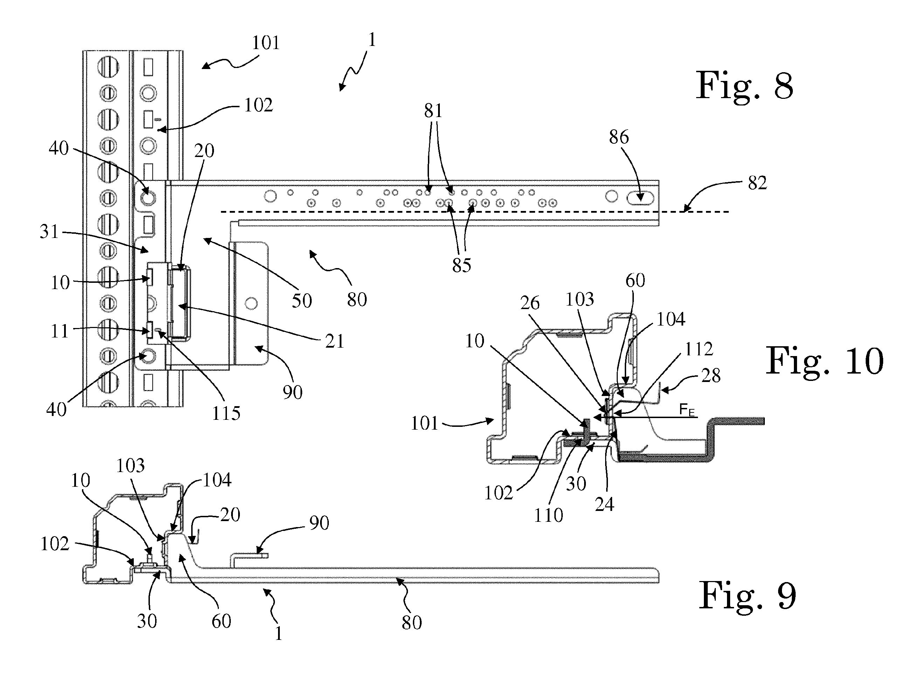

Such second elastically deformed position is illustrated for example in figure 10, where the force F_{E} exerted by the protruding portions 23 and 24 on the second wall 102 is schematically illustrated as a whole by an arrow.

According to the exemplary embodiment illustrated in figures 1-4 and 8-10, indication marks 115 are defined along the outer surfaces of at least one of the first and second walls 102, 103, for indicating to the operator which holes 110 use for the insertion of the teeth 10, 11 and/or which holes 112 use for engaging with the spring 20. In this way, the bracket 1 can be mounted at predetermined indicated positions along the lengthwise extension of the frame member 101, positions which are chosen by the operator according to the devised application of the bracket 1. Preferably, a grasping portion 27 is associated to the spring 20 for disengaging the spring 20 from the corresponding second holes 112; more preferably, the grasping portion 27 is a portion of the spring 20 itself.

For example, in the embodiment illustrated in figures 5 and 6, the grasping portion 27 transversally connects to each other the two folded tracts 25, 26 of the protruding portions 23 and 24, and comprises a tab 28 which is particularly adapted to be easily grasped by an operator.

A force applied by the operator is transmitted through the grasping portion 27 to the protruding portions 23 and 24, so as to overcome the force F_{E} and cause an elastic deformation of the protruding portions 23, 24 away from the second wall 103 of the frame member 101.

Such elastic deformation causes the disengagement of the folded tracts 25, 26 from the corresponding second holes 112, so as the bracket 1 can be easily removed from the frame member 101, just removing the teeth 10, 11 from the corresponding first holes 110 with a single operation occurring along a linear direction.

Preferably, the bracket 1 comprises a connecting element 70 which is adapted to connect the bracket 1 to one or more components and/or accessories associable to the frame 100, such as a plate 200 for supporting one or more electronic and/or electrical devices of the switchboard.

The connecting element 70 is sliding mounted on a corresponding elongated portion 80 of the bracket 1, and it is adapted to be positioned at a plurality of predetermined positions along the elongated portion 80. Preferably, indication marks 81 are defined along the elongate portion 80, for visually indicating the predetermined positions at which the sliding connecting element 70 can be positioned.

In the exemplary embodiment illustrated in figures 1-4 and 7-10, the main body 2 of the bracket 1 comprises the elongate portion 80 which extends lengthwise from the flat portion 50, along a principal axis which is illustrated for example and indicated with numeral reference "82" in figure 8. In particular, the illustrated elongated portion 80, seen in a transversal cross section with respect to the principal axis 82, has a C-shaped profile defined by a base wall 83 and two lateral edges 84 faced to each other.

For example, a plurality of indentations 85 are defined along the base wall 83 for providing fixing points which define the predetermined positions at which the connecting element 70 can be positioned relative to elongated portion 80. Accordingly, a plurality of reference holes 81 are defined along the base wall 83 for visually signaling each one of the fixing points 85.

A slot 86 is defined at the end of the elongated portion 80 which is opposed to the flat portion 50. The slot 86 is adapted to optionally connect the bracket 1 to another vertical structural element associated to the frame 100, such as another frame member parallel to the frame member 101 or a vertical panel connected to the frame 100.

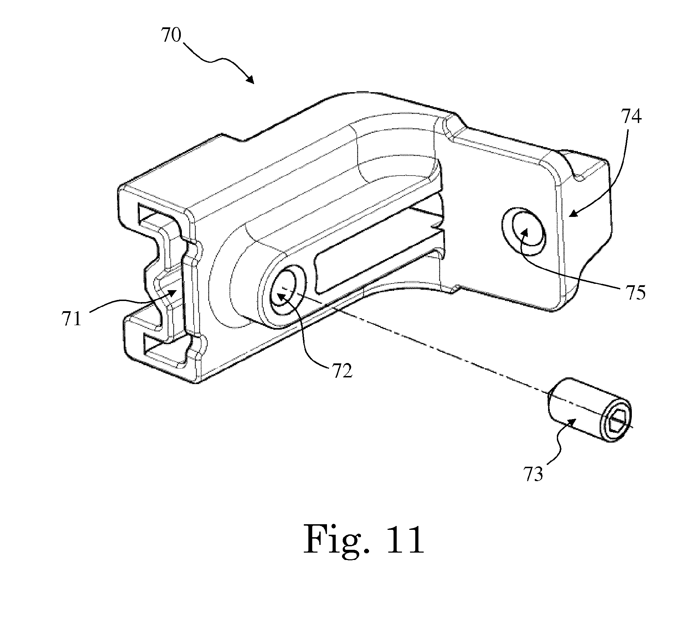

With reference to the exemplary embodiment illustrated in figure 11, the connecting element 70 has a hollow portion 71 with an internal space adapted to be crossed by a corresponding tract of the elongated portion 80. The internal space of the hollow portion 71 is accessible by a hole 72, in such a way that fixing means 73 can be inserted through the hole 72 for coupling with a corresponding indentation 85 of the elongated portion 80.

Furthermore, the connecting element 70 comprises a portion 74 which is arranged transversally with respect to the hollow portion 71, wherein a through hole 75 is defined across the portion 74. The through hole 75 allows the use of fixing means for connecting the sliding element 70 to the corresponding component and/or accessory associable to the frame 100.

The operative coupling between the bracket 1 and the corresponding frame member 101 is herein disclosed by making particular reference to the exemplary embodiments of bracket 1 and frame member 101 illustrated in figures 1-10.

First, the bracket 1 is moved along the linear mounting direction illustrated by the arrow in figure 1, in such a way that the flat surface 30 approaches the first wall 102 of the frame member 101 and the linear insertion of the teeth 10, 11 in the chosen first holes 110 starts.

During such linear insertion, the protruding portions 23 and 24 of the spring 20 interact with and are elastically repulsed by the second wall 103, from the rest position to the first elastically deformed position.

Further, the portions 60 and 61 slide onto the second wall 103 during the insertion of the teeth 10, 11 in the corresponding first holes 110. Hence, the portions 60 and 61 advantageously act as guiding elements for such insertion.

The insertion of the teeth 10, 11 in the corresponding first holes 110 ends when the flat surface 30 abuts against the fist wall 102 of the frame member 101.

In particular, when the flat surface 30 abuts against the first wall 102, the folded portions 25 and 26 of the protruding portions 23 and 24 reach and insert into the corresponding second holes 112 of the second wall 103. This insertion causes the elastic return of the protruding portions 23 and 24, from the first elastically deformed position towards the rest position.

In particular, the second wall 103 blocks the elastic return of the protruding portions 23, 24 at the second elastically deformed position, between the rest and first elastically deformed positions; in this way, the spring 20 continues to exert the force F_{E} directed towards and acting on the second wall 102.

Further, when the flat surface 30 abuts against the first wall 102, the shaped portions 60 and 61 of the bracket 1 abut against the third wall 104 of the frame member 101; hence, the shaped portions 60, 61 advantageously act as stopping elements for the linear mounting movement of the bracket 1.

The final situation is illustrated for example in figure 10; with reference to such figure, the teeth 10, 11 inserted into the corresponding first holes 110 block a linear displacement of the bracket 1 towards the right with respect to the illustrated frame member 101.

The contact between the shaped portions 60, 61 and the second wall 103 blocks a linear displacement of the bracket 1 towards the left with respect to the illustrated frame member 101. The folded tracts 25 and 26 of the spring 20 inserted into the corresponding second holes 112 block a low linear displacement of the bracket 1 with respect to the illustrated frame member 101.

The contact between the surface 30 and the first wall 102 and the contact between the shaped portions 60 and 61 and the third wall 104 block an upper linear displacement of the bracket 1 relative to the illustrated frame member 101.

Hence, the only way to disengage the bracket 1 from the frame member 101 is disengaging the protruding portions 23, 24 from the corresponding second holes 112, so as to allow the low linear displacement of the bracket 1 relative to the illustrated frame member 101.

To this aim, the operator can easily acts on the grasping portion 27 of the spring 20 to overcome the force F_{E} and cause an elastic deformation of the protruding portions 23 and 24 away from the second wall 103, until disengaging the folded tracts 25 and 26 from the corresponding second holes 112. At this point, the operator can easily remove the bracket from the frame member 1, with only a single operation occurring along a linear direction.

The bracket 1 is stably mounted on the frame member 101, without requiring fixing means; a subsequent use of fixing means is optional.

Indeed, the only coupling to the frame member 101 provided by the teeth 10, 11 and the spring 20 allows a correct working of the bracket 1 in applications where the bracket 1 is not subjected to a critical mechanical stress.

In view of applications implying a critical mechanical stress, the operator can easily performs an auxiliary screwing operation using the fixing holes 40, while the bracket 1 is correctly and stably mounted on the frame member 101.

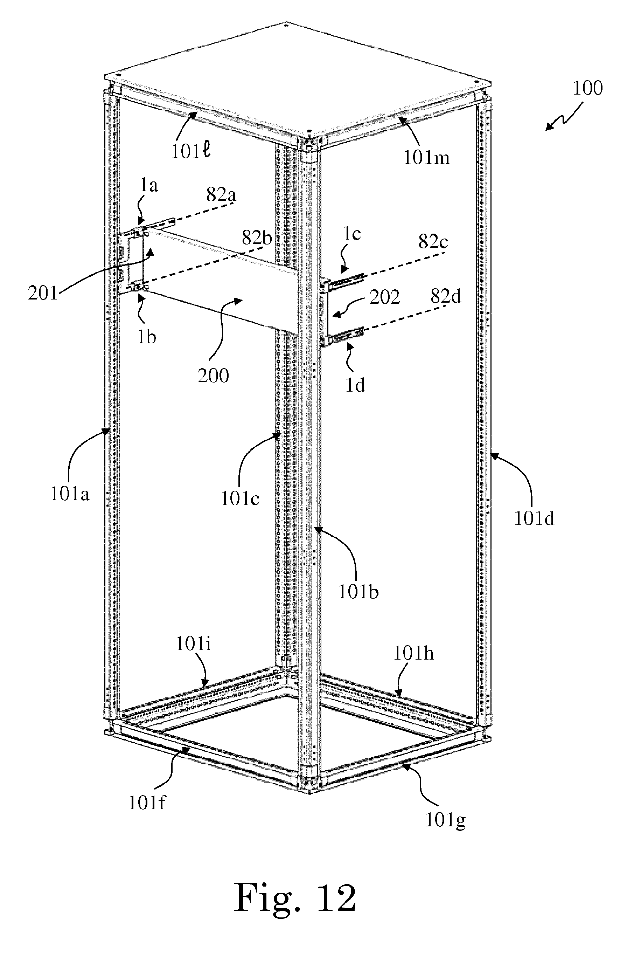

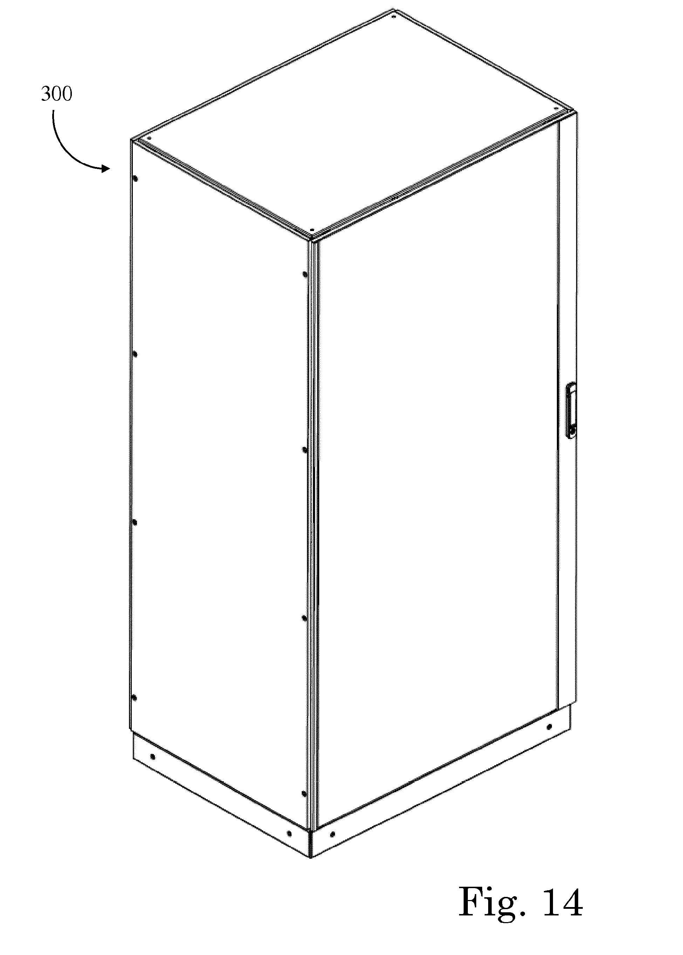

With reference to figures 12-14, the present invention is also related to a cabinet 300 for an electric switchboard, and related switchboard.

Such cabinet 300 comprises the frame 100 having at least a first frame member 101a as the above disclosed frame member 101, and at least a first bracket 1a as the above disclosed bracket 1, which is operatively connected to the first frame member 101a.

In particular, the flat surface 30 of the first bracket 1a abuts against the first wall 102 of the first frame member 101a, and the teeth 10, 11 protruding transversally with respect to such surface 30 are inserted into the corresponding first holes 110 of the first wall 102. The protruding portions 23, 24 of the spring 20 are engaged with the corresponding second holes 112 of the second wall 103; in particular, the folded tracts 25 and 26 are inserted into the corresponding second holes 112.

In the exemplary embodiment illustrated in figure 12, the frame 100 has a substantially parallelepiped structure defined by frame members 101f-101m used as cross-members or rails (i.e. arranged substantially horizontally), and by a plurality of frame members 101a-101d used as uprights (i.e. arranged substantially vertically).

All the illustrated frame members 101a-101d and 101f-101m are frame members as the above disclosed frame member 101.

In particular, the above mentioned first frame member 101a is a first upright 101a which is transversally connected to a second upright 101b by the cross members 101f and 1011, and which is transversally connected to a third upright 101c by a first cross member 101i and a second cross member (not viewable in figure 12).

The bracket 1a is operatively coupled to the first upright 101a so as to extend lengthwise along a first principal axis 82a, towards the third upright 101c.

With reference to figures 12-13, the cabinet 300 further comprises a second bracket 1b as the above disclosed bracket 1, which is operatively connected to the first upright 101a so as to extend lengthwise along a second principal axis 82b, towards the third upright 101c.

In particular, the flat surface 30 of the second bracket 1b abuts against the first wall 102 of the first upright 101a, and the teeth 10, 11 protruding transversally with respect to such surface 30 are inserted into corresponding first holes 110. The protruding portions 24, 25 of the spring 20 are engaged with the corresponding second holes 112 of the second wall 103.

The first and second brackets 1a, 1b are operatively coupled to the same upright 101a so as to define a first mounting structure for a plate 200 associable to the frame 100, such as an internal plate 200 of the frame 100 for supporting one or more electric devices of the switchboard.

In the exemplary embodiment illustrated in figures 12-13, the sliding connecting elements 70 of the first and second brackets 1a, 1b are positioned on the corresponding elongated portions 80 so as to be aligned to each other. In this way, a first end 201 of the plate 200 can be connected to the two connecting elements 70.

For example, the first end 201 is mounted on the portions 74 of the two connecting elements 70, and the through holes 75 are used for fixing the first end 201 to such portions 74.

With reference to figures 12-13, the cabinet 300 preferably further comprises a third bracket 1c and a fourth bracket 1d as the above disclosed bracket 1, which are operatively connected to the second upright 101b.

In particular:
- the flat surfaces 30 of the third and fourth brackets 1c, 1d abut against the first wall 102 of the second upright 101b;
- the teeth 10, 11 of the third and fourth brackets 1c, 1d are inserted into corresponding first holes 110 of the first wall 102 of the second upright 101b; and
- the protruding portions 23, 24 of the spring 20 of the third and fourth brackets 1c, 1d are engaged with the corresponding second holes 112 of the second wall 103 of the second upright 101b.

The third and fourth brackets 1c, 1d extend lengthwise along a third principal axis 82c and a fourth principal axis 82d, respectively, towards a fourth upright 101 which is transversally connected to the second upright 101b by the cross members 101g and 101m.

The third and fourth brackets 1c and 1d are operatively coupled to the same upright 101b so as to define a second mounting structure for the plate 200; this second mounting structure facing the first mounting structure defined by the first and second brackets 1a, 1b.

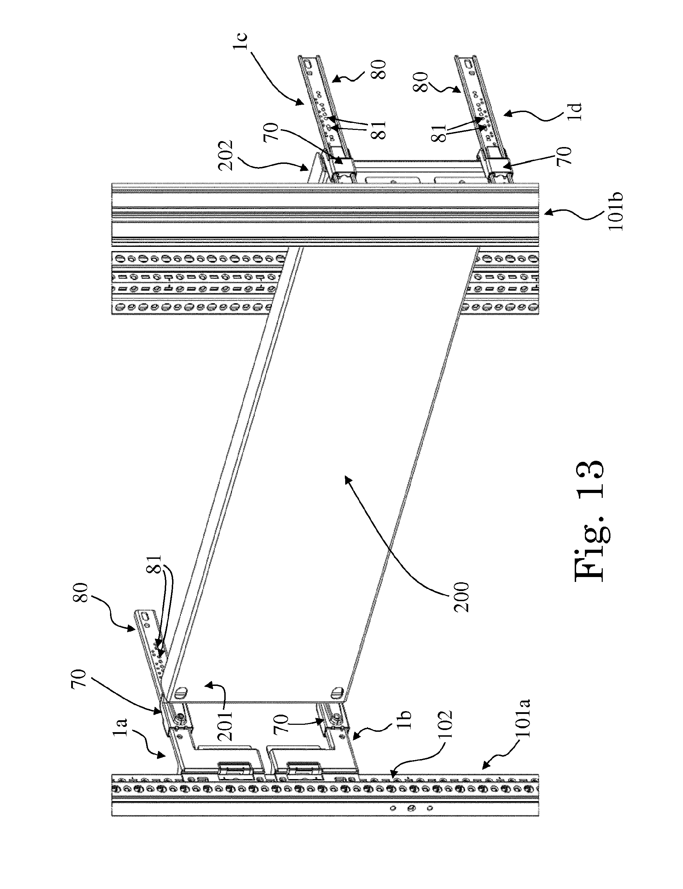

In the exemplary embodiment illustrated in figures 13-14, the sliding connecting elements 70 of the third and fourth brackets 1c, 1d are positioned on the corresponding elongated portions 80 so as to be aligned to each other. In this way, a second end 202 of the plate 200, opposed to the first end 201, can be connected to the two connecting elements 70.

For example, the second end 202 is mounted on the portions 74 of the two connecting elements 70, and the through holes 75 are used for fixing the second end 202 to such portions 74.

Advantageously, the first and second brackets 1a and 1b can be operatively coupled to the first upright 101a spaced to each other by a distance which is variable by changing the first holes 110 into which the teeth 10, 11 are inserted. In the same way, the third and fourth brackets 1c, 1d can be operatively connected to the upright 101b spaced to each other by a distance which is variable by changing the first holes 110 into which the teeth 10, 11 are inserted.

In this way, the distance between the first and second brackets 1a, 1b and the distance between the third and fourth brackets 1c, 1d can be varied according to the dimension of the plate 200.

According to the exemplary embodiment illustrated in figures 12-13, the lengthwise extension of the first and second brackets 1a, 1b along the respective first principal axis 82a and second principal axis 82b is delimited in such a way that the first and second brackets 1a and 1b are spaced from the third upright 101c.

In the same way, the lengthwise extension of the third and fourth brackets 1c, 1d along the respective third principal axis 82c and fourth principal axis 82d is delimited in such a way that the third and fourth brackets 1c and 1d are spaced from the fourth upright 101d.

In this way, the ends of the first and second brackets 1a, 1b pointing towards the third upright 101c and the ends of the third and fourth brackets 1c, 1d pointing towards the fourth upright 101d can remain free, i.e. disengaged from any other structural element or component, for applications where the brackets 1a-1d are not subjected to a critical mechanical stress.

In view of applications involving a relevant mechanical stress on the brackets 1a-1d, the ends of the first and second brackets 1a, 1b and the ends of the third and fourth brackets 1c-1d can be connected to corresponding vertical structural elements associated to the frame 100, such as a first vertical panel mounted between the first and third uprights 101a, 101c and a second vertical panel mounted between the second and fourth uprights 101b, 101d.

For example, in the embodiment illustrated in figures 12 and 13, the slots 86 of the elongated portions 80 of the brackets 1a-1d can be used to connect the brackets 1a-1d to the corresponding vertical structural elements.

According to a preferred but not limiting application of the brackets 1a-1d, the panel 200 is used for supporting one or more switching devices of the switchboard.

As well-known in the art, such switching devices can be of the fixed type or the withdrawable type; in particular, the withdrawable switching devices have dimensions and weight greater than the fixed switching devices.

Hence, if used for supporting the fixed switching devices, the plate 200 can be positioned at predetermined positions near to the uprights 101a, 101b, by using the sliding connecting elements 70 of the brackets 1a-1d.

In this case, the brackets 1a-1b are not subjected to a critical mechanical stress by the plate 200 and the fixed switching devices mounted thereon. Hence, the only coupling of the brackets 101a-101d to the respective uprights 101a, 101b provided by the teeth 10, 11 and springs 20 is enough to allow a correct working of the brackets 101a-101d to support the plate 200 and related fixed switching devices.

If used for supporting withdrawable switching devices, the plate 200 is positioned at predetermined positions far from the uprights 101a, 101b, by using the sliding connecting elements 70 of the brackets 1a-1d.

In this case, the brackets 1a-1d can be subjected to a critical mechanical stress by the plate 200 and the withdrawable switching devices mounted thereon. Hence, the fixing holes 40 of the brackets 1a-1d can be used to realize an additional connection to the respective uprights 101a and 101b and/or the slots 86 can be used to connect the free ends of the brackets 1a-1d to corresponding vertical structural elements associated to the frame 100. In this way, the brackets 1a-1d can safety withstand the plate 200 and related withdrawable switching devices.

In practice, it has been seen how the bracket 1 according to the present disclosure, and related cabinet 300 and switchboard, allow achieving the intended object offering some improvements over known solutions.

In particular, only a single, simple, fast and intuitive mounting operation of the bracket 1 on the corresponding frame member 101 is required to an operator.

Also the removal operation of the bracket 1 from the frame member 101 is a single, simple, fast and intuitive operation which, according to the exemplary embodiment of figures 1-10, can be assisted by the grasping portion 27 associated to the elastic means 20.

The operative coupling of the bracket 1 to the frame member 101, provided by the insertion of the protruding elements 10, 11 in the corresponding first holes 110 and the elastic return and engagement of the elastic means 20 with the corresponding second holes 112, is effective and stable.

For applications where a critical mechanical stress is not applied to the bracket 1, such effective and stable coupling does not require a further use of fixing means for the connection to the frame member 101 and/or a use of further vertical structural elements associated to the frame 100, according to an economic solution with a reduced number of elements.

For applications where a critical mechanical stress is applied to the bracket 1, fixing means can be used for the connection to the frame member 101 and/or further vertical structural elements for supporting the bracket 1. However, the pre-mounting of the bracket 1 to the frame member 101, provided by the protruding elements 10, 11 and the elastic means 20, allows a correct stable and effective positioning of the bracket 1 on the frame member 101. Such positioning makes the subsequent fixing operations on the bracket 1 easier, faster and adapted to be performed only by one operator.

The bracket 1 thus conceived, and related cabinet 300 and switchboard, are also susceptible of modifications and variations, all of which are within the scope of the inventive concept as defined in particular by the appended claims.

For example, even if the exemplary bracket 1 illustrated in the attached figures comprises two teeth 10, 11, the number of teeth can be different to the illustrated one; for example, the bracket 1 can comprise only one tooth, or more than two teeth.

Alternatively to the illustrated teeth 10, 11, at least one element can protrude transversally with respect to the flat surface 30 for being inserted in a corresponding circular hole 113, when the flat portion 30 abut against the first wall 102. For example, one or more pins protruding transversally from the flat portion 30 can be provided.

For example, even if the exemplary spring 20 illustrated in the attached figures comprises two protruding portions 23, 24, the number of such protruding portions 23, 24 can be different to the illustrated one; for example, the spring 1 can comprise only one protruding portion, or more than two portions 23, 24.

Alternatively, the spring 20 can comprises a single protruding portion having a plurality of spaced folded tracts, each one adapted to be inserted in a corresponding rectangular second hole 112.

For example, even if the illustrated shaped portions 60, 61 are adapted both to slide on the second wall 103 and abut against the third wall 104, the bracket 1 can comprise one or more first shaped portions adapted to abut against the third wall 104 when the flat surface 30 abuts against the first wall 102, and one or more second shaped portions adapted to slide on the second wall 103 during the insertion of the teeth 10, 11 in the corresponding first hole 100 (and to remain in contact with the second wall 102 when the flat surface 30 abuts against the first wall 102). Alternatively to the illustrated folded tracts 25 and 26, the protruding portions 23 and 24 of the spring 20 can have tracts adapted to be inserted in corresponding circular holes 113 of the frame member 101, when the flat surface 30 abuts against the first wall 102.

Moreover, all parts/components can be replaced with other technically equivalent elements; in practice, the type of materials, and the dimensions, can be any according to needs and to the state of the art.

## Claims

1. A mounting bracket (1) adapted to be operatively connected to the frame (100) of a cabinet (300) for an electrical switchboard, said frame (100) comprising at least one frame member (101) having at least a first wall (102) which comprises a plurality of first holes (110, 111) and a second wall (103) which comprises a plurality of second holes (112, 113) and which is arranged transversal with respect to said first wall (102), said mounting bracket (1) **characterized in that** it comprises:
- a flat surface (30) adapted to abut against said first wall (102);
- at least one element (10, 11) which protrudes transversally with respect to said flat surface (30) and which is adapted to be inserted into a corresponding one of said first holes (110) by abutting said flat surface (30) against the first wall (102);
- elastic means (20) adapted to interact with and be elastically repulsed by said second wall (103) during the insertion of said at least one element (10, 11) into the corresponding first hole (110), and to elastically return and engage with corresponding one or more of said second holes (112) when the flat surface (30) abuts against the first wall (102) and said at least one element (10, 11) is inserted into the corresponding first hole (110).

2. The mounting bracket (1) according to claim 1, wherein said elastic means (20) are adapted to exert a force (F_{E}) directed towards and acting on said second wall (103), after said elastically return and engagement of the elastic means (20) with the corresponding one or more second holes (112).

3. The mounting bracket (1) according to claim 1 or claim 2, comprising a grasping portion (27) associated to said elastic means (20) for disengaging the elastic means from said corresponding one or more second holes (112).

4. The mounting bracket (1) according to one or more of the preceding claims, wherein said elastic means (20) are operatively coupled to a corresponding seat (3) defined in the mounting bracket (1).

5. The mounting bracket (1) according to one or more of the preceding claims, wherein said elastic means comprise a spring (20) having a flat portion (21) arranged substantially parallel to said flat surface (30), and at least one portion (23, 24) which protrudes transversally from said flat portion (21) and which comprises a folded tract (25, 26), said folded tract (25, 26) being adapted to engage with a corresponding one of said second holes (112) when said flat surface (30) abuts against the first wall (102) and said at least one element (10, 11) is inserted into the corresponding first hole (110).

6. The mounting bracket (1) according to one or more of the preceding claims, comprising at least one fixing hole (40) defined on said flat surface (30).

7. The mounting bracket (1) according to one or more of the preceding claims, comprising at least one shaped portion (60, 61) adapted to abut against a third wall (104) of the frame member (101) which is transversally connected to said second wall (103), when said flat surface (30) abuts against the first wall (102) and said at least one element (10, 11) is inserted in the corresponding first hole (110).

8. The mounting bracket (1) according to one or more of the preceding claims, comprising at least one shaped portion (60, 61) adapted to slide onto the second wall (103) during the insertion of said at least one element (10, 11) into the corresponding first hole (110).

9. The mounting bracket (1) according to one or more of the preceding claims, comprising a connecting element (70) which is sliding mounted on a corresponding elongated portion (80) of the mounting bracket (1), said sliding connecting element (70) being adapted to be positioned at a plurality of predetermined positions along the elongated portion (80).

10. The mounting bracket (1) according to claim 9, wherein indication marks (81) are defined along said elongate portion (80) for visually indicating said predetermined positions.

11. A cabinet (300) for an electrical switchboard, comprising a frame (100) having at least a first frame member (101a), said first frame member (101a) having at least a first wall (102) which comprises a plurality of first holes (110, 111) and a second wall (103) which comprises a plurality of second holes (112, 113) and which is arranged transversal with respect to said first wall (102), said cabinet (300) **characterized in that** it comprises at least a first mounting bracket (1a) according to one or more of the preceding claims 1-10, wherein:
- said flat surface (30) of the first mounting bracket (1a) abuts against said first wall (102);
- said at least one element (10, 11) of the first mounting bracket (1a) is inserted into a corresponding one of said first holes (110); and
- said elastic means (20) of the first mounting bracket (1a) are elastically returned and engaged with corresponding one or more of said second holes (112).

12. The cabinet (300) according to claim 11, further comprising a second mounting bracket (1b) according to one or more of the preceding claims 1-10, wherein:
- said flat surface (30) of the second mounting bracket (1b) abuts against said first wall (102) of the first frame member (101a);
- said at least one element (10, 11) of the second mounting bracket (1b) is inserted into a corresponding one of said first holes (110); and
- said elastic means (20) of the second mounting bracket (1b) are elastically returned and engaged with corresponding one or more of said second holes (112);
said first and second mounting brackets (1a, 1b) defining a mounting structure for a plate (200) associable to the frame (100).

13. The cabinet (300) according to claim 12, comprising said plate (200) operatively connected to said mounting structure (1a, 1b).

14. An electrical switchboard **characterized in that** it comprises a cabinet (300) according to one or more of the claims 11-13.
